Europäisches Patentamt

European Patent Office

Office européen des brevets

(11) Publication number: **0 048 536**
A2

# EUROPEAN PATENT APPLICATION

(21) Application number: 81302105.2

(22) Date of filing: 12.05.81

(51) Int. Cl.³: **H 01 L 21/477**
H 01 L 41/18, H 01 L 41/22
H 01 B 3/00

(30) Priority: 18.09.80 JP 130410/80
03.12.80 JP 171230/80
04.12.80 JP 171884/80

(43) Date of publication of application:
31.03.82 Bulletin 82/13

(84) Designated Contracting States:
DE FR GB

(71) Applicant: Matsushita Electric Industrial Co., Ltd.
1006, Oaza Kadoma
Kadoma-shi Osaka-fu, 571(JP)

(72) Inventor: Inada, Masanori
7-77 Oaza-Ichihara
Heguri-cho Ikoma-gun Nara-ken(JP)

(72) Inventor: Horibe, Yasutaka
3-9-615, Mizuo
Ibaraki-shi Osaka-fu(JP)

(74) Representative: Crawford, Andrew Birkby et al,
A.A. THORNTON & CO. Northumberland House 303-306
High Holborn
London WC1V 7LE(GB)

(54) Sintered body of lead titanate and method of manufacturing same.

(57) Powders of lead titanate consisting of acicular, plate-like crystalline particles of tetragonal lead titanate which are elongated in the direction of the a-axis are manufactured from acicular particles of tetragonal titanium dioxide of anatase type or from titanium dioxide hydrate particles which are mixed with powders of lead oxide or lead-containing compounds and the resulting mixture is fired. Alternatively, potassium titanate fibers of the general formula $K_2O. nTiO_2$ may be used in place of the titanium compounds. Grain oriented sintered bodies of lead titanate can be manufactured from said powders.

EP 0 048 536 A2

Croydon Printing Company Ltd.

SINTERED BODY OF LEAD TITANATE AND METHOD

OF MANUFACTURING SAME

The present invention relates to a grain-oriented lead titanate (referred to as $PbTiO_3$ hereinafter) which is remarkably useful as a piezoelectric material and a method of manufacturing same.

In the field of magnetic materials, powdery acicular or columnar crystalline particles of magnetic materials, especially iron oxides, which are elongated in the specific direction of crystal, have been manufactured from long ago. A film or a sheet of a composite material, in which acicular or columnar crystalline particles of magnetic materials are oriented in one direction, has been manufactured from the mixture of said powdery acicular or columnar crystalline particles of magnetic materials, especially iron oxides, which are elongated in the specific direction of crystal, and organic substances. Such materials have been widely used for magnetic tapes and the like. Also in the field of magnetic materials, the sintered body, in which crystal grains of magnetic materials are oriented in one direction, has been manufactured from the powdery mixture, at least one component of which is particles of special shape such as acicular or columnar, by "hot-pressing" said powdery mixture. Such a sintered body has been widely used practically as materials for magnetic heads of video tape recorders and the like because it is a magnetic material in which magnetic characteristics are remarkably dependent upon directions.

As described above, in the field of magnetic materials such materials, of which remarkable anisotropy of magnetic crystal in respect of magnetic properties is utilized, have been widely used practically, while in the field of dielectric materials and piezoelectric materials which have been widely used as materials for electronics like magnetic materials such materials, of which anisotropy of crystal in respect of dielectric characteristic and piezoelectric characteristic is utilized, have been hardly manufactured. Although there have been some reports concerning the grain-oriented sintered body of layer bismuth compounds, its material is considerably inferior to perovskite compounds, which have played a leading part in the field of dielectric materials and piezoelectric materials, in respect of dielectric characteristic and piezoelectric characteristic.

On the other hand, the sintered body of perovskite compounds, in particular those of titanate such as $BaTiO_3$, $PbTiO_3$, $PbTiO_3$-$PbZrO_3$ and the like is remarkably superior in respect of dielectric characteristic and piezoelectric characteristic and thus it has been widely used practically for various kinds of part in which piezoelectric characteristic and dielectric characteristic are utilized. It can be seen from the fact that dielectric characteristic and piezoelectric characteristic of these materials are largely dependent upon axial directions of crystal that the sintered body of these materials, in which crystal grains are oriented, if manufacturable, will be remarkably improved in its performance, and thereby its new application field will be sufficiently extended. The grain-oriented sintered body of perovskite compounds has been desired because of the above described reason. But it has never been obtained so far.

As to layer bismuth compounds, sintering by not pressing leads to the easy formation of crystal grains of which layer structure is oriented vertically to the pressing direction, and thereby the grain-oriented sintered body can be formed because they have a layer crystal structure. On the contrary, as to perovskite compounds, their sintered body, in which crystal grains are oriented, can not be obtained if the regular raw materials of which particles are not characterized in respect of shape are used because their crystal structure does not contain any characteristic structural portions such as layer structure in which crystal grains are liable to orient.

The following methods of manufacturing the grain-oriented sintered body can be thought of:

(1) A method of manufacturing the grain-oriented sintered body, in which the powdery material consisting of acicular or columnar particles having the specific crystal orientation is used as the raw material and mixed with other raw materials, and its mixture is molded under the condition that such particles are oriented in the definite direction and then the resulting molded product is sintered;

(2) A method of manufacturing the grain-oriented sintered body, in which the powdery final material consisting of particles having the specific shape and the specific crystal orientation is prepared using the same raw material as described in (1) or by other methods and then the resulting powdery material is molded under the condition that particles are orientated in the definite direction followed by sintering the resulting molded product; and the like.

According to the present invention, the powdery material consisting of acicular and plate-like particles of $PbTiO_3$ is prepared from fibers of potassium titanate, the powdery acicular particles of anatase type $TiO_2$ and the powdery acicular particles of $TiO_2 \cdot n\ H_2O$, and the new grain-oriented sintered body of $PbTiO_3$ is manufactured according to the above described method (1) or (2), using the resulting powdery material of anatase type $TiO_2$,

$TiO_2 \cdot H_2O$ and the powdery $PbTiO_3$.

The sintered body of $PbTiO_3$, which has a remarkably large difference between its planar electro-mechanical coupling coefficient $k_p$ and its electro-mechanical coupling coefficient in the direction of thickness $k_t$, small dielectric constant, remarkably high Curie point of about $470^\circ C$, high heat reasistance and the like, is the material remarkably useful as an infrared thermometer and a piezoelectric resonator of VHF range. In addition, this material has a great future as the material for an ultrasonic sensor used in taking a tomogram of human body which is making a remarkable progress recently. As to the grain-oriented sintered body according to the present invention, one of crystal axes of each crystal grain is situated in the poling direction and other crystal axes are situated vertically to the poling direction; and thus spontaneously polarized directions of almost all of crystal grains are situated in the same direction, and thereby $k_t$ is remarkably increased and piezoelectric characteristic can be improved. These advantages lead to not only the remarkable improvement of performance of an infrared thermometer and a material for an ultrasonic sensor but also the development of the new uses of the sintered body of $PbTiO_3$.

The powdery material consisting of acicular and plate-like particles of $PbTiO_3$ is remarkably important for the manufacture of the above described grain-oriented sintered body of PbTiO$_3$. It was the reason why such PbTiO$_3$ particles and the grain-oriented sintered body of PbTiO$_3$ could be manufactured that potassium titanate fiber, TiO$_2 \cdot n$H$_2$O, and anatase type TiO$_2$ have common structural elements, in which TiO$_6$ octahedra, constructing a chain structure, are linked at their apexes and in parallel with each other, in their crystal structures; and in addition, they have a particle shape elongated in the direction of such a bonding; and furthermore, also titanate perovskite compounds such as PbTiO$_3$ have the same kind of bonding structure of TiO$_6$ octahedra as that described above, in their crystal structures, in which the direction of such a bonding is situated in the direction of three crystal axes.

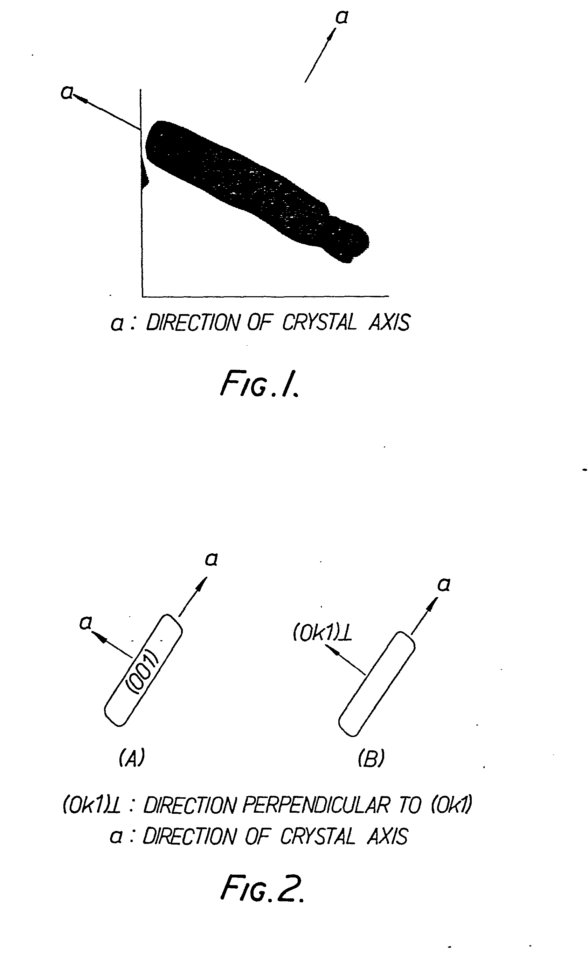

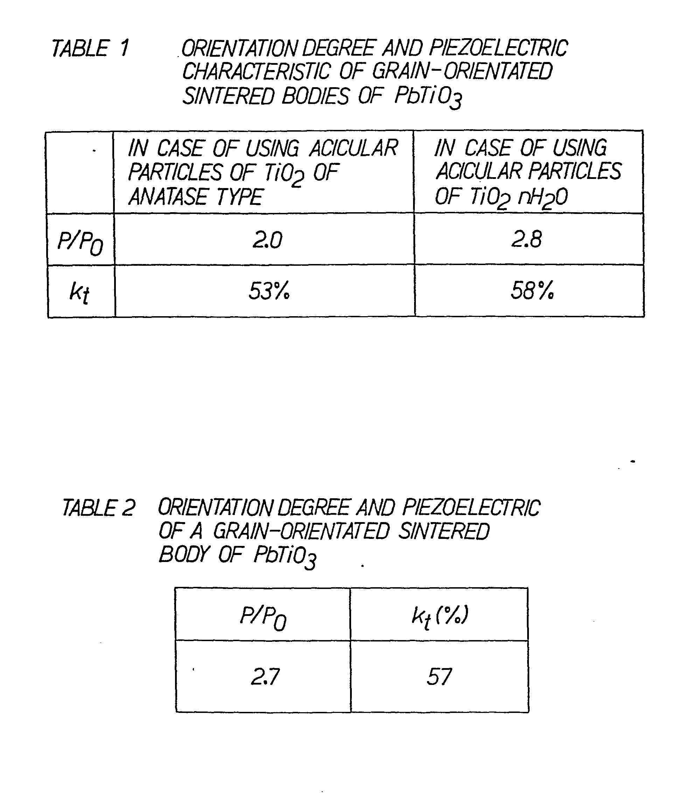

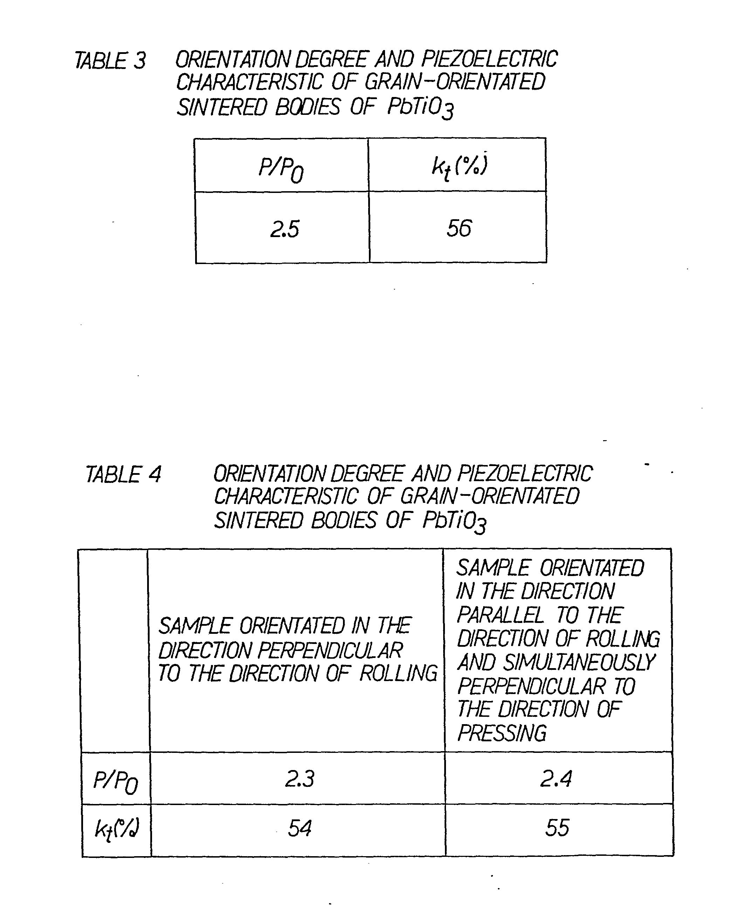

The present invention will be described in detail in the following preferred embodiments by reference to the annexed drawings, in which FIG. 1 is a photograph showing particles of PbTiO$_3$ manufactured according to the present invention and FIG. 2 is a diagram showing the directions of crystal axes of PbTiO$_3$ particles shown in FIG. 1.

EXAMPLE 1

At first, potassium tetratitanate (K$_2$O $\cdot$4TiO$_2$) fibers are prepared by "flux" method. That is to say, the powdery mixture consisting of potassium carbonate (K$_2$CO$_3$), titanium dioxide (TiO$_2$) and potassium molybdate (K$_2$MoO$_4$) at the molar ratio of 6 : 24 : 70. is fired in a platinum crucible at a temperature of 1,100$^\circ$C for 2 hours and then cooled at the speed of 4$^\circ$C/hour. The resulting reaction product is sufficiently washed to remove $K_2MoO_4$ component completely and then dried to obtain $K_2O \cdot 4TiO_2$ fibers. Then 50g of the resulting $K_2O \cdot 4TiO_2$ fibers are held in 5$\ell$ of 1 N hydrochloric acid for 10 hours and then washed sufficiently and dried. The resulting powdery sample consists of acicular particles of $TiO_2 \cdot nH_2O$ having a grain size of 5 to 40 micrometer. This powdery sample is subjected to heat treatment at a temperature of 850$^\circ$C for 1 hour. It was found from the results of an electron-microscopy analysis and an electron-diffraction analysis that the resulting powdery sample consisted of acicular particles of anatase type $TiO_2$ elongated in the direction of $a$-axis and having a grain size of 1 to 10 micrometer. Then the resulting powdery $TiO_2 \cdot nH_2O$ and anatase type $TiO_2$ are mixed with powders of $Pb(COO)_2$ and PbO, respectively, at the equivalent molar ratio and the mixtures are fired at a variety of temperatures in the range of 650 to 1,200$^\circ$C. It was found from the results of an X-ray diffraction analysis that the resulting powdery samples consisted of a single phase of $PbTiO_3$. In addition, a particle shape and crystal orientation of the resulting powdery samples were examined by an electron-microscopy analysis and an electron-diffraction analysis. It was found that acicular

and plate-like particles of $PbTiO_3$ as shown in Fig. 1 were obtained at a temperature lower than about 1,200°C when the separation of particles was somewhat more inferior because sintering was promoted. It was also found from the results of an electron-diffraction analysis on crystal orientation of a variety of particles that almost all of them were acicular and plate-like particles elongated in the direction of a-axis and having a well-developed crystal plane which was c-plane or near it, as shown by a particle of A type and B type in FIG. 2, in addition, particles of A type and those of B type were recognized at almost the same rate. Particles of A type had a well-developed c-plane and particles of B type showed k of 1 to 6. Plate-like particles having k of 4 or more have an angle of 13.2° or less between a perpendicular line$((Ok1)\perp)$ to (Ok1) plane and a-axis and consequently also an angle between a perpendicular line to a plate-surface of a particle and c-axis is 13.2° or less. The larger k is, the smaller said angle is. The plate-surface of these particles is near c-plane. Even particles having k of 3 have an angle of 17.4° between a perpendicular line to a surface of a sample and c-axis and hence the plate-surface near c-plane. Particles of B type having k of 4 or more are recognized at the rate of about 50% or more. Consequently, the resulting powdery samples almost consist of plate-like particles with a well-developed plane which is c-plane or near it.

Example 2

Potassium titanate fibers shown by the composition of $K_2O \cdot nTiO_2$ (n = 4, 6) are prepared by "flux" method in which $K_2MoO_4$ is used as flux. That is to say, the mixture consisting of $K_2CO_3$, $TiO_2$ and $K_2MoO_4$ at the molar ratio of 6 : 24 : 70 or 4.3 : 25.7 : 70 is fired in a platinum crucible at a temperature of $1,100^\circ C$ and $1,200^\circ C$, respectively and then cooled to room temperature at the speed of $4^\circ C$/hour. The resulting reaction products are washed by cold water to remove flux and dried. It was found from the results of X-ray diffraction analysis, an electron-microscopic analysis and an electron-diffraction analysis that the resulting potassium titanate fibers obtained from the mixture consisting of $K_2CO_3$, $TiO_2$ and $K_2MoO_4$ at the molar ratio of 6 : 24 : 70 and 4.3 : 25.7 : 70 consisted of $K_2O$ $4TiO_2$ and $K_2O$ $6TiO_2$, respectively and were elongated in the direction of the crystal axis.

Then these samples were mixed with powders of PbO, $Pb(NO_3)_2$, $Pb(COO)_2$ and the like at the molar ratio of 1 : 4 and 1 : 6, respectively and the mixtures were fired at a temperature of 800, 900 and $1,000^\circ C$. It was found from the results of X-ray diffraction analysis that $PbTiO_3$ and potassium-containing unknown substances were formed regardless of the sort of compounds of lead. These potassium-containing unknown substances can be easily dissolved and removed by holding them in water overnight and then washing them. The dried powdery samples consist of a single phase of PbTiO$_3$. The shape and crystal orientation of particles forming the resulting powdery samples were examined by an electron-microscopy analysis and an electron-diffraction analysis. Almost all particles were acicular and plate-like ones of A type and B type in FIG. 1 which is 0.5 to 2 micrometer long and *elongated* in the direction of a-axis. They included particles having k of 1 to 6.

Example 3

The powdery samples of TiO$_2$·nH$_2$O and anatase type TiO$_2$ prepared by the same method shown in Example 1 were mixed with a small amount of lanthanum oxide (La$_2$O$_3$) and manganese dioxide (MnO$_2$), which had been used as additives for PbTiO$_3$ to be sintered, at the molar ratio of 0.975 : 0.015 : 0.010 by a wet method. The resulting mixture of 100 parts by weight was mixed with polybinyl butylral resin of 15 parts by weight, n-butyl-phthalate of 15 parts by weight and isopropylalcohol of 25 parts by weight and the resulting composite was extruded into thread-like products of 0.5 mmØ. The resulting thread-like products were cut by 15 mm long and then the resulting thread-like products of 15 mm long were placed in parallel in one direction followed by pressing in a mold to obtain molded products of 15 x 15 x 10 mm.
After holding at 400°C for 5 hours to remove organic
binders, the resulting molded products were sintered at
1,250°C for 2 hours to obtain rectangular parallelepiped sintered
bodies. After the surface layer of these sintered bodies was
removed by abrading the plane perpendicular to the direct-
ion in which thread-like molded products were placed in
parallel, said plane was subjected to X-ray diffraction ana-
lysis. It was found from the results of X-ray diffraction
analysis that the diffraction intensity for c-plane and a-
plane such as (001), (100), (002) and (200) was remarkably
larger than that for other crystal planes. The orientation degree for c-plane and a-plane can be evaluated by
$P/P_o$ for convenience' sake, assuming that the ratio of a
total of the integral intensity of diffraction lines for c-plane and
a-plane such as (001), (100), (002) and (200), $\Sigma(I_{hoo} + I_{ool})$
to a total of an integral intensity of diffraction lines for
$PbTiO_3$, $\Sigma I$, is P ($P = \Sigma(I_{hoo} + I_{ool})/\Sigma I$) and that for an un-grain-
oriented sintered body is $P_o$. $P/P_o$ of the grain-oriented
sintered bodies manufactured in examples were shown in
Table 1, it being 2.0 in case of anatase type $TiO_2$ and
2.8 in case of $TiO_2 \cdot nH_2O$. It is the reason for the above
described fact that the elongation of $TiO_2 \cdot nH_2O$ is
remarkably larger than that of anatase type $TiO_2$.

Then the disk samples of 0.3 mm thick and 6 mmØ

perpendicular to the direction in which thread-like molded products were placed in parallel were prepared by slicing these sintered bodies, into disks. Silver electrodes were formed on both sides of these disk samples by the vacuum deposition method, and the samples were subjected to polying for 10 min.

at 200°C and 60 kV/cm, and then an electro-mechanical coupling coefficient in the direction of thickness $k_t$ was measured. The results of this measurement are shown in Table 1. It was found from Table 1 that $k_t$ was 58 % in case of $TiO_2 \cdot nH_2O$ and 53 % in case of anatase type $TiO_2$ which were remarkably larger than 43% of that of the conventional un-grain-oriented sintered body of $PbTiO_3$.

Then the similar experiments as the above described excepting that lead monoxide (PbO) was used instead of Pb-$(COO)_2$ were carried out. The results were obtained that were almost the same as those when $Pb(COO)_2$ was used.

The grain-oriented sintered body of $PbTiO_3$ obtained by this method contains crystal grains having one of their crystal axes parallel to the poling direction and other axes perpendicular to the poling direction. Accordingly, $k_t$ is remarkably increased and piezoelectric characteristic can be remarkably impoved because almost all of crystal grains have the same spontaneous polarization direction.

Example 4

The powdery samples consisting of acicular and plate-like particles of PbTiO$_3$ prepared by the methods shown in Example 1 and 2 were mixed with a small amount of lantanum oxide (La$_2$O$_3$) and manganese dioxide (MnO$_2$), which had been used as additives for sintering PbTiO$_3$, at the molar ratio of 0.975 : 0.015 : 0.010. The resulting mixture of 100 parts by weight was mixed with polyvinyl butylral resin of 15 parts by weight, n-butylphthalate of 15 parts by weight and isopropyl alcohol of 25 parts by weight and the resulting composite was extruded into thread-like products of 0.5 mm∅. The resulting thread-like products were cut by 15 mm long and then these thread-like products of 15 mm long were placed in parallel in one direction followed by pressing in a mold to obtain molded products of 15 x 15 x 10 mm. After holding at 400°C for 5 hours to remove organic binders, the resulting molded products were fired at 1,250°C for 2 hours to obtain rectangular parallelepiped sintered bodies. After the surface layer of these sintered bodies was removed by abrading the plane perpendicular to the direction in which thread-like molded products were placed in parallel, said plane was subjected to X-ray diffraction analysis. It was found from the results of X-ray diffraction analysis that the diffraction intensity for c-plane and a-plane was remarkably larger than that for other crystal

0048536

planes and $P/P_o$ was 2.7 as shown in Table 2. These facts can show that both c-planes and a-planes of crystal grains are effectively oriented in the planes of samples. Although the powdery $PbTiO_3$ used as a raw material consists of particles elongated substantially in the direction of a-axis and the sintered body is manufactured by sintering the molded product in which elongated particles are placed in the same direction, the so-called 90°-domain structure is formed in the sintering process and thus both a-axis orientation and c-axis orientation are generated in the same direction.

Then the disk samples of 0.3 mm thick and 6 mmØ perpendicular to the direction in which thread-like molded products were placed in parallel were prepared by slicing these sintered bodies and processing the resulting thin plates into disks. Silver electrodes were formed on both sides of these disk samples by the vacuum deposition method and the resulting samples were subjected to poling for 10 min. at 200°C and 60 kV/cm, and then an electro-mechanical coupling coefficient in the direction of thickness $k_t$ was measured. The results of this measurement are shown in Table 2. $k_t$ of these disk samples was 57% which was remarkably larger than 43% of that of the conventional un-grain-oriented sintered body.

Example 5

Sheet materials of about 2 mm thick were obtained by rolling the mixture prepared by the method shown in Example 4. The resulting sheet materials were punched to obtain disks of 1 cm$\emptyset$. After holding at $400^{\circ}$C for 5 hours to remove organic binders, these disks were sintered at 1,250$^{\circ}$C for 2 hours to obtain the sintered body of PbTiO$_3$. After the surface layer of these sintered bodies was removed by abrading the surface of these sintered bodies, said surface was subjected to X-ray diffraction analysis. It was found from the results of X-ray diffraction analysis that the diffraction intensity for c-plane and a-plane such as (001), (100), (002) and (200) was remarkably larger than that for other crystal planes. The orientation degree for c-plane and a-plane can be evaluated by P/P$_0$ for convenience' sake, assuming that the ratio of a total of the integral intensity of diffraction lines for c-plane and a-plane such as (001), (100), (002) and (200), $\Sigma(I_{hoo} + I_{ool})$, to a total of an integral intensity of diffraction lines for PbTiO$_3$, $\Sigma I$, is P (P $= \Sigma(I_{hoo} + I_{ool})/\Sigma I$) and that for an un-grain-oriented sintered body is P$_0$. P/P$_0$ of the grain-oriented sintered bodies manufactured in this example was 2.5 as shown in Table 3. These facts can show that both c-planes and a-planes of particles are effectively oriented in the planes of samples. Although the powdery PbTiO$_3$ used as a raw material consists of particles having a well-developed c-plane and the sintered body is manufactured by sintering the

0048536

molded product in which c-planes of particles are placed in parallel, the so-called 90°-domain structure is formed in the sintering process, and thereby both c-axis orientation and a-axis orientation are generated in the same direction.

Then silver electrodes were formed by the vacuum deposition method on both sides of the disk samples of 0.3 mm thick and 6 mmØ which were made from these sintered bodies by the same method as that described in above Examples and the resulting samples were subjected to poling for 10 min. at 200°C and 60 kV/cm, and then an electro-mechanical coupling coefficient $k_t$ was measured. The results of this measurement are shown in Table 3. $k_t$ of the sintered body obtained in this example was 56% which was remarkably larger than 43% of that of the conventional un-grain-oriented sintered body of $PbTiO_3$.

Example 6

Sheet materials of about 2 mm thick were obtained by rolling thread-like products prepared by the method shown in Example 4 under the condition that they were placed in parallel in the same direction. The molded products of 15 x 15 x 10 mm were obtained by pressing these sheet materials under the condition that they were placed one upon another with parallel directions of rolling. After holding at 400°C for 5 hours to remove organic binders, said molded products were sintered at 1,250°C for 2 hours to obtain sintered bodies. Thin plate materials oriented parallel to the direction of rolling and perpendicular to the direction of pressing as well as thin plate materials oriented perpendicular to the direction of rolling were obtained by slicing said sintered bodies. It was found from the results of X-ray diffraction analysis that the diffraction intensity for c-planes and a-planes such as (001), (100), (002) and (200) was remarkably larger than that for other crystal planes. The orientation degree for c-plane and a-plane can be evaluated by $P/P_o$ for convenience' sake, assuming that the ratio of a total of the integral intensity of diffraction lines for c-plane and a-plane such as (001), (100), (002) and (200), $\Sigma(I_{hoo} + I_{ool})$, to a total of an integral intensity of diffraction lines for $PbTiO_3$, $\Sigma I$, is P ($P = \Sigma(I_{hoo} + I_{ool})/\Sigma I$) and that for an un-grain-oriented sintered body is $P_o$. $P/P_o$ of said thin plate materials was, as shown in Table 4, 2.3 in case of those grain-oriented in the direction perpendicular to the direction of rolling and 2.4 in case of those grain-oriented in the direction parallel to the direction of rolling and perpendicular to the direction of pressing. These facts can show that c-planes and a-planes of particles constructing said sintered bodies are effectively oriented in the planes of samples. Although the powdery $PbTiO_3$ used as a raw material consists of acicular and plate-like particles elongated substantially in the direction of a-axis and having a well-developed c-plane, and the sintered body is manufactured by sintering the molded product in which a-axis of particles are placed in parallel in the same direction and simultaneously c-planes of particles are placed in parallel, the so-called 90°-domain structure is formed in the sintering process, and thereby both c-axis orientation and a-axis orientation are generated in the same direction.

Then the disk samples of 0.3 mm thick and 6 mmØ was prepared by the same method as that described in above Examples. Silver electrodes were formed on both sides of these disk samples by the vacuum deposition method and resulting samples were subjected to poling for 10 min. at 200°C and 60 kV/cm, and then an electro-mechanical coupling coefficient in the direction of thickness $k_t$ was measured. The results of this measurement are shown in Table 4. $k_t$ of these disk samples was 54% in case of that grain-oriented in the direction perpendicular to the direction of rolling and 55 % in case of that grain-oriented in the direction parallel to the direction of rolling and simultaneously perpendicular to the direction of pressing which were remarkably larger than 43% of that of the conventional un-grain-orientated sintered body.

Although potassium titanate fibers, of which composition is expressed by $K_2O \cdot nTiO_2$ where in n is 4 or 6, are used in Example 2, those, wherein n is 1 or 2, are also known. As already described, potassium titanate fibers have common structural elements, in which $TiO_6$ octahedra, constructing a chain structure, are linked at their apexes and in parallel with each other, in their crystal structures; and in addition, they have a particle shape elongated in the direction of such a bonding; and furthermore, also titanate perovskite compounds such as $PbTiO_3$ have the same kind of bonding structure of $TiO_6$ octahedra as that described above, in their crystal structures, in which the direction of such a bonding is situated in the direction of three crystal axes. Such a crystal structure leads to the formation of crystalline particles of perovskite compound, $PbTiO_3$, elongated in the direction of a crystal axis. Consequently, also potassium titanate fibers, of which composition is expressed by $K_2O \cdot nTiO_2$ wherein n is 1 or 2, are similarly effective as Examples. In addition, although firing is carried out at 800, 900 and 1,000°C, it may be carried out at other temperatures. After all, it is important that by the reaction of potassium titanate with lead-containing compounds, which decompose at a high temperature to form PbO, $PbTiO_3$ is formed at a higher temperature and potassium-containing components which are produced by such a reaction are removed. Although in Examples the resulting potassium-containing components are removed by washing, they may be naturally removed by hot water, acids and the like.

A method of manufacturing particles of $PbTiO_3$ shown in Examples 1 and 2 can be applied also to the manufacture of particles having the specific shape such as acicular of other compounds, which have the same bonding structure of $TiO_6$ octahedra

as in $PbTiO_3$, such as $BaTiO_3$, $SrTiO_3$, $CaTiO_3$ and the like.

Although the powdery material of $Pb(COO)_2$, $PbO$, $Pb(NO3)_2$ and the like were used as lead-containing compounds in Examples 1 to 5, it goes without saying that other lead-containing compounds, which form powders of $PbO$ by heating, may be used.

Although $La_2O_3$ and $MnO_2$ were used as additives in Examples 3 to 5, it goes without saying that a small amount of oxides, which have been used for controlling dielectric characteristic and piezoelectric characteristic, such as $MgO$, $SiO_2$, $SrO$, $CoO$, $Bi_2O_3$, $CaO$ and the like may be added.

CLAIMS: -

1. Powders of lead titanate, characterized by that they substantially consist of crystalline particles of tetragonal lead titanate which are elongated in the direction of a-axis and have an acicular and plate-like shape.

2. Powders of lead titanate, characterized by that they substantially consist of crystalline particles of tetragonal lead titanate which have a well-developed c-plane and a plate-like shape.

3. Powders of lead titanate, characterized by that they substantially consist of crystalline particles of tetragonal lead titanate which are elongated in the direction of a-axis, having a well-developed c-plane, and having a acicular and plate-like shape.

4. A method of manufacturing powders of lead titanate, characterized by that acicular particles of tetragonal titanium dioxide of anatase type elongated in the direction of a-axis or powders of acicular particles of titanium dioxide hydrate which form said acicular particles of tetragonal titanium dioxide of anatase type elongated in the direction of a-axis by heat treatment are mixed with powders of lead oxide or powders of lead-containing compounds which form lead oxide by heating and the resulting mixture is fired.

5. A method of manufacturing powders of lead titanate, characterized by that potassium titanate fibers of which composition is expressed by the general formula $K_2O \cdot nTiO_2$ are mixed with powders of lead oxide or powders of lead-containing compounds which form lead oxide by heating and the resulting mixture is fired to obtain tetragonal particles of lead titanate of acicular and plate-like shape, and then the isolated potassium-containing component is dissolved and removed by water or acids from particles of lead titanate.

6. A grain-oriented sintered body of lead titanate, characterized by that one of crystal axes of tetragonal crystal grains of lead titanate constructing said sintered body are orientated substantially in the same direction.

7. A sintered body of lead titanate, characterized by that three crystalline axes of tetragonal crystal grains constructing said sintered body are oriented substantially in three directions which meet at right angles with each other.

8. A method of manufacturing a sintered body of lead titanate, characterized by that powders of acicular particles of tetragonal titanium dioxide of anatase type elongated in the direction of a-axis or powders of acicular particles of titanium dioxide hydrate which form said acicular particles of tetragonal titanium dioxide of anatase type elongated in the direction of a-axis by heating are mixed with lead oxide or lead-containing compounds which form lead oxide by heating and a small amount of additives and the resulting mixture is molded to obtain molded products in which said acicular particles are placed substantially in the same direction, and then the resulting molded products are sintered.

9. A method of manufacturing a grain-oriented sintered body of lead titanate set forth in claim 6, characterized by that powders as shown in claim 1 are mixed with a small amount of additives and the resulting mixture is molded to obtain molded products in which particles of lead titanate are placed substantially in the same direction, and then the resulting molded products are sintered.

10. A method of manufacturing a grain-oriented sintered body of lead titanate, characterized by that powders as shown in claim 2 are mixed with a small amount of additives and the resulting mixture is molded to obtain molded products in which plate surfaces of said particles of lead titanate are placed in parallel, and then the resulting molded products are sintered.

11. A method of manufacturing a grain-oriented sintered body of lead titanate set forth in claim 7, characterized by that powders as shown in claim 3 are mixed with a small amount of additives and the resulting mixture is molded to obtain molded products in which plate surfaces of said particles of lead titanate are placed in parallel and said particles of lead titanate are placed in the same direction, and then the resulting molded products are sintered.

a : DIRECTION OF CRYSTAL AXIS

FIG.1.

(A)                    (B)

(0k1)⊥ : DIRECTION PERPENDICULAR TO (0k1)
a : DIRECTION OF CRYSTAL AXIS

FIG.2.

TABLE 1    ORIENTATION DEGREE AND PIEZOELECTRIC CHARACTERISTIC OF GRAIN-ORIENTATED SINTERED BODIES OF $PbTiO_3$

| | IN CASE OF USING ACICULAR PARTICLES OF $TiO_2$ OF ANATASE TYPE | IN CASE OF USING ACICULAR PARTICLES OF $TiO_2 \, nH_2O$ |
|---|---|---|
| $P/P_0$ | 2.0 | 2.8 |
| $k_t$ | 53% | 58% |

TABLE 2    ORIENTATION DEGREE AND PIEZOELECTRIC OF A GRAIN-ORIENTATED SINTERED BODY OF $PbTiO_3$

| $P/P_0$ | $k_t \, (\%)$ |
|---|---|
| 2.7 | 57 |

TABLE 3   ORIENTATION DEGREE AND PIEZOELECTRIC
CHARACTERISTIC OF GRAIN-ORIENTATED
SINTERED BODIES OF $PbTiO_3$

| $P/P_0$ | $k_t (\%)$ |
|---|---|
| 2.5 | 56 |

TABLE 4   ORIENTATION DEGREE AND PIEZOELECTRIC
CHARACTERISTIC OF GRAIN-ORIENTATED
SINTERED BODIES OF $PbTiO_3$

| | SAMPLE ORIENTATED IN THE DIRECTION PERPENDICULAR TO THE DIRECTION OF ROLLING | SAMPLE ORIENTATED IN THE DIRECTION PARALLEL TO THE DIRECTION OF ROLLING AND SIMULTANEOUSLY PERPENDICULAR TO THE DIRECTION OF PRESSING |
|---|---|---|
| $P/P_0$ | 2.3 | 2.4 |
| $k_t (\%)$ | 54 | 55 |